Europäisches Patentamt

European Patent Office

Office européen des brevets

(11) Publication number: **0 317 144 B1**

# EUROPEAN PATENT SPECIFICATION

(45) Date of publication of patent specification: **03.03.93** (51) Int. Cl.⁵: **H03K 19/018**

(21) Application number: **88310443.2**

(22) Date of filing: **07.11.88**

(54) **True TTL to true ECL bi-directional TRI state translator driver circuit.**

(30) Priority: **20.11.87 US 123486**

(43) Date of publication of application:
**24.05.89 Bulletin 89/21**

(45) Publication of the grant of the patent:
**03.03.93 Bulletin 93/09**

(84) Designated Contracting States:
**DE FR GB IT SE**

(56) References cited:
**EP-A- 0 176 244**
**WO-A-85/02507**
**WO-A-86/02792**

**IEEE INTERCON CONFERENCE, vol. 6, 1975, pages 18/3,1-8; J. BUIE: "3D-LSI compatible logic family"**

(73) Proprietor: **TANDEM COMPUTERS INCORPO- RATED**
**19333 Vallco Parkway**
**Cupertino California 95014-2599(US)**

(72) Inventor: **Khan, Aurangzeb K.**
**287 Linden**
**San Bruno California 94066(US)**

(74) Representative: **Ayers, Martyn Lewis Stanley et al**
**J.A. KEMP & CO. 14 South Square Gray's Inn**
**London, WC1R 5EU (GB)**

Rank Xerox (UK) Business Services
(3.10/3.5x/3.0.1)

## Description

The present invention relates to integrated circuits, and, more particularly, to circuits for translating from Emitter Coupled Logic (ECL) to Transistor-Transistor Logic (TTL).

Many present day digital computers include bi-directional buses for transmitting data and control signals to and from various sub systems. Such systems often include integrated circuits connected to the bus which have bi-directional drives/receivers, or transceivers connected to the same signal pad or pin. In such systems the transceiver functionality is achieved by connecting the output drivers output circuit line and the input receivers input circuit line to the same I/O signal pad or pin.

Examples of prior logic level converters include: WO 86/02792 which discloses converter for correcting logic levels between ECL and TTL levels, but does not provide a bi-directional TTL bus; and EPA-0176224 relates to a Schottky transistor TTL, rather than ECL, level translator with a tri-state capability.

Additionally, for example, copending application EP-A-0317145 entitled " TTL to ECL Input Translator Driver Circuit" shows a receiver circuit, and copending application EP-A-0317143 entitled " TTL Output Translator Driver with ECL Tri-State Control" shows a driver circuit. The two circuits shown in these applications could be connected to the same I/O signal pad or pin.

Many integrated circuit chips are I-O bound, that is, the area of the chip is controlled by the number of I-O bonding pads required to get signals on and off the chip. In such chips, there generally is adequate space for the actual logic circuits. However, in some modern technology such as TAB technology, the I-O bonding pads are very closely spaced and there are substantially more I-O bonding pads available. In such circuits the area density of the I-O logic circuits becomes a critical factor. Stated differently, the smaller the area required for I-O units, the smaller the overall chip dimensions possible. Such chip dimensions are desirable because they result in higher yield and lower cost.

The present invention addresses the problem of I-O circuit cell density in a situation where a common bonding pad is used for a bi-directional driver/receiver. Conventional transceivers which have two distinct functional circuit blocks, that is, a separate receiver circuit and a separate driver circuit, are relatively high in both component count and in use of silicon chip real estate. High component count and high use of silicon chip real estate has negative implications with respect to parameters such as die size, chip cost, yield, chip logic functional capability, etc.

An object of the present invention is to provide a low cost, high density driver/receiver integrated circuit.

Another object of the present invention is to provide a driver/receiver that uses a relative small amount of silicon real estate.

Yet another object of the present invention is to provide a combined receiver/driver circuit for a bi-directional bus.

A still further object of the present invention is to provide a driver/receiver integrated circuit that can interface true ECL logic to a bi-directional true TTL bus.

The present invention provides an integrated circuit that has both driver and receiver functions. The circuit of the present invention has two interrelated parts. The first part of the circuit converts true TTL signals to true ECL signals. The second part of the circuit accepts true ECL signals and drives a tri-state true TTL bus. The novel design of the present invention provides a common circuit that acts as an input reference for the circuit that converts true TTL signals to true ECL signals and as a stable tri-state clamp for the circuit that accepts true ECL signals and drives a tri-state true TTL bus. Using the sane circuit components to perform functions in two separate circuits reduces the component count of the resulting circuit and increases the circuit's power/device count figure of merit.

Thus, according to one aspect of the invention, there is provided a combined driver receiver circuit coupled to receive true TTL signals from and provide true TTL signals to a bi-directional TTL bus, comprising:

a dual purpose circuit, including a plurality of circuit elements arranged in series circuit configuration between a first supply voltage representing the TTL supply potential and a second supply voltage representing the ECL and TTL reference potential, the dual purpose circuit being operable as an input reference generator for providing an input reference and a tri-state output clamp voltage;

an input receiver circuit operable to receive and translate the true TTL signals from the bi-directional TTL bus to true ECL level signals, the input receiver circuit utilizing the input reference voltage of said dual purpose circuit means;

an output driver circuit for accepting true ECL level signals and for providing therefrom true TTL level signals to the bi-directional TTL bus utilizing the tri-state output clamp voltage of the dual purpose circuit;

circuit means connecting both the input receiver circuit and the output driver circuit to the bi-directional TTL bus.

The invention will be further described by way of example with reference to the accompanying drawings, in which:-

Figure 1 shows the true TTL to true ECL converter part of an embodiment of the invention.

Figure 2 shows the tri-state control circuit part of an embodiment of the invention.

Figure 3 shows, in block diagram form, the combined circuit of the present invention.

The terms "true TTL" and "true ECL" are used herein in the conventional sense. The terms "true TTL" and "true ECL" positively distinguish from the terms "pseudo TTL" and "pseudo ECL". In general, true TTL voltages are in the range of zero to plus five volts, and true ECL voltages are negative in the range of zero to minus two volts. Pseudo TTL voltages have a five volt difference between the high and low states, but the voltages are negative, that is, pseudo TTL signals are from zero to minus five volts. Pseudo ECL signals have about a two volt range, but they are positive, that is, they range from zero to plus two volts.

Copending application EP-A-0317145 entitled "TTL to ECL Input Translator Driver Circuit" shows a separate receiver circuit. Copending application EP-A-0 317 143 entitled "TTL Output Translator Driver with ECL Tri-State Control" shows a separate driver circuit. The circuits shown in the above two patent applications can be used separately, or both circuits can be placed on the same chip and connected to the same I/O bonding pad and package pin. The present invention provides a combined circuit that performs the same function as would be performed by both circuits.

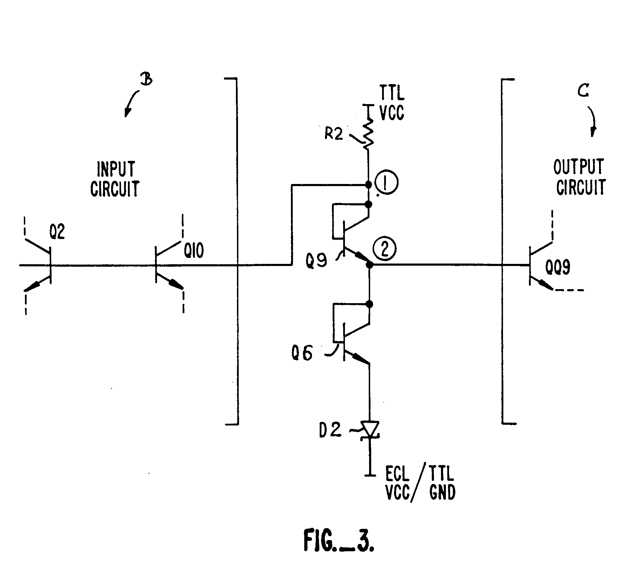

The two circuits shown in the above-referenced patent applications can be combined in a novel manner to provide an economical circuit that performs both functions utilizing a minimum of components and a minimum amount of chip real estate. Such a combined circuit, designated with the reference letter A, is shown in Figure 3 in block diagram form.

In the novel circuit of the present invention, the I/O transceiver (i.e., the receiver and the tri-state bus driver) A is one combined circuit. The output driver designated C in Figure 3 and the input receiver designated B in Figure 3 are implemented using the techniques explained in the previously referenced patent applications. However, the circuits are combined in a unique way to achieve lower cost in device count and silicon real estate compared to the conventional solution of using two independent circuits.

As shown in Figure 3, resistor R2, transistors Q9 and Q6, and diode D2 form a part of both circuits.

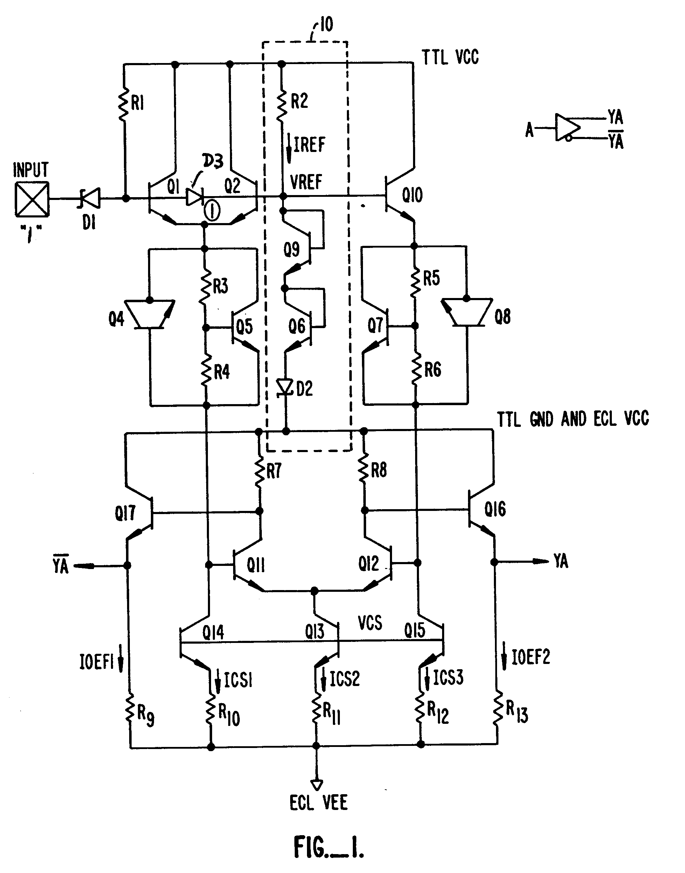

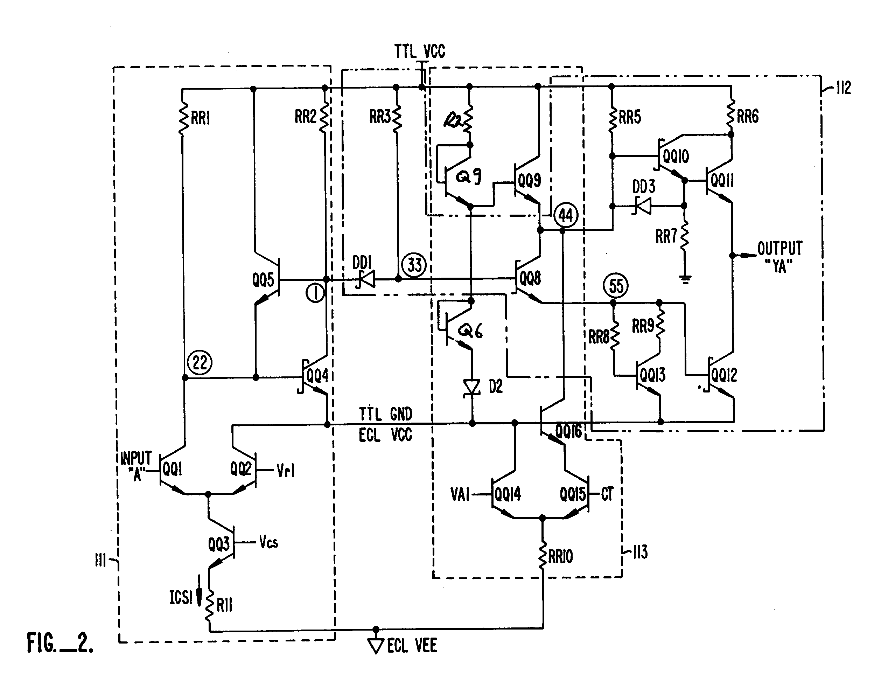

As Figure 3 illustrates, the circuit elements R2, Q9, Q6 and D2 (cumulatively designated with the reference number 10) perform joint functions for the receiver circuit B and the tri-state bus driver circuit C. The circuit 10 develops a reference voltage (Vref) against which input signal I (Figure 1) is compared in the receiver B. At the same time, as will be discussed below with reference to the description and operation of the tri-state bus drive circuit C (Figure 2), the circuit 10 operates to develop a clamp voltage that is used to hold the output circuits of the tri-state bus driver C in a stable, high-impedance state when the ECL signal control signal CT is asserted.

The detailed operation of the circuit shown in Figure 1 will first be explained. Next, the detailed operation of the circuit shown in Figure 2 will be explained. Finally, the operation of the combined circuit shown in Figure 3 will be explained.

The input function, that is, the translation of true TTL signals to true ECL signals is performed by the circuit shown in Figure 1. The circuit in Figure 1 includes resistors R1 to R13, transistors Q1 to Q16, and diodes D1 and D2. The circuit shown in Figure 1 operates as follows:

True TTL Input Reference Voltage Threshold: Devices D2, Q6, Q9 and R2, which cumulatively form the circuit 10 (Figure 3), define the input reference threshold for the TTL input circuit.

(i) $\quad V_{ref} = V_{sd}(D2) + V_{be}(Q6) + V_{be}(Q9)$

$V_{be}$ is the nominal forward voltage of the bipolar transistor Q9 (and Q6) , and $V_{sd}$ is the nominal forward voltage of the Schottky barrier diode, D2 (and D1). The $V_{be}$, $V_{sd}$ voltages are set by the device characteristics as a function of the device current. Device current is set by,

$$VCC - I_{ref}*R2 - V_{be}(Q9) - V_{be}(Q6) - V_{sd}(D2) = 0$$
$$I_{ref} = \{VCC - V_{be}(Q9) - V_{be}(Q6) - V_{sd}(D2)\} / R2$$

Let $V_{be}(Q6) = V_{be}(Q7) = V_{be}$ and $V_{sd}(D2) = V_{sd}(D1) = V_{sd}$, by design.

(ii) $\quad V_{ref} = V_{sd} + 2V_{be}$, and $V(Q2) = V_{ref}$.

In this way, this circuit section provides the base of Q2 with $V_{ref} = 2V_{be} + V_{sd}$. Note that the true reference voltage as observed at the input is $2V_{be}$, since $V_{sd}(D2)$ and $V_{sd}(D1)$ cancel.

The performance of this circuit across the voltage temperature stress envelope tracks the behavior of the conventional circuit. Thus, this reference introduces no new system level electrical design constraints.

True TTL Input Clamped Level-Shifting Comparator: Devices R1, Q1, Q2 and D3 are used to develop a small, ECL-like voltage at the emitter-tie node, labelled node 1, from the large TTL input voltage transitions. This is accomplished as follows.

Let the input "I" be at VIL, where, with respect to TTL GND,

VILmin = 0.0 V < = VIL < = 0.8 V = VILmax

Then, D1 conducts IIL current, which is defined by,

IIL = {VCC - Vsd(D1) - VIL} / R1

Consequently, the base of Q1 attains a voltage,

(iii)     Vb(Q1) = VIL + Vsd.

From the analysis presented above (Eq. ii) it should be noted that,

Vb(Q2) = Vref = Vsd + 2Vbe.

Since 2Vbe is a higher voltage than VILmax, Vb(Q1) is lower than Vb(Q2). Therefore, transistor Q2 develops a full Vbe and goes into forward-active conduction, while transistor Q1 attains < 0.5Vbe and is considered cut-off. Hence, V(1) follows Vb(Q2), and the current source Ics1 (Q14/R10) is satisfied by Q2, via R3, R4 and Q5. In this way, the V(1) low level is established.

(iv)     V(1)LOW = Vbe + Vsd.

Next, let the input "I" be at VIH, where, with respect to TTL GND,

(v)     VIHmin = 2.0 V < = VIL < = 5.0 V = VIHmax

Since VIHmin is a higher voltage than 2Vbe, D1 conducts reverse-leakage current only. IIH current is conducted through R1 to D3 into the input reference voltage circuit.

IIH = {VCC - Vbe(D3 - Vref} / R1

Diode D3 (which, in implementation is the base-emitter junction of a transistor acts as a clamp on Vb(Q1), such that with the input at any voltage greater than VIHmin, e.g., 3Vbe,

(vi)     Vb(Q1)max = Vbe(D3) + Vref = Vbe(D3) + 2Vbe + Vsd

(vii)     Vb(Q1)max = 3Vbe + Vsd

From the analysis presented above (Eq. ii) it should be noted that,

Vb(Q2) = Vref = Vsd + 2Vbe.

Vb(Q1) is a higher voltage than Vb(Q2). Therefore, transistor Q1 develops a full Vbe and goes into forward-active conduction, while transistor Q2 attains < 0.5Vbe and is considered cut-off. Hence, V(1) follows Vb(Q1) and the current source Ics1 (Q14/R10) is satisfied by Q1, via R3, R4 and Q5.

In this way, the V(1) high level is established.

(viii)     V(1)HIGH = 2Vbe + Vsd.

It should be clear from the operation of the circuit, as explained above, that this circuit is substantially different from a conventional TTL input comparator. The conventional circuit utilizes the same comparator reference, but converts input voltage into pseudo-ECL levels, and then later converts these to true-ECL using the conventional resistor ladder approach. In the novel technique developed in this document, the input stage can be described as a clamped, switched emitter-follower.

Self-Centering Reference Threshold Translator: The operation of the Vref-translator circuit is as follows. Let Ics3 represent the current required to satisfy the current source set-up by Q15 and R12.

Ics3 = {VCS - Vbe(Q15)} / R12

Ics3 is sourced by the parallel combination of transistor Q7 and resistor R6. The Ics3 value must be chosen to provide adequate current to bias transistor Q7 in the forward-active mode while also allowing I(R6) to be satisfied. A first order approximation

I(R6) = Vbe(Q7) / R6 and,
Ie(Q7) = Ics3 - I(R6).

Note that Vbe(Q7) is in fact a function of Ie(Q7).

V(R5) = R5 * I(R6) + {Ie(Q7) / (Hfe + 1)}

where Hfe is the current gain of Q7. Therefore, by an appropriate choice of R5, we can set-up an appropriate amount of total voltage level shift provided by this circuit. Let us choose,

(ix)     R5 : R6 - 2.5 : 1.

Then, if we define Hfe to be a large positive number,

(x)     V(R5) = 2.5 * V(R6) = 2.5 * Vbe(Q7)

Therefore, the total voltage translation from the emitter of transistor Q10 to the base of transistor Q12 is set to be 3.5Vbe.

From our earlier discussion (Eq. ii),

Vref = Vsd + 2Vbe.

Hence, applying the voltage translation derived above, we find that,

Vb(Q12) = Vref - Vbe(Q10) - 3.5Vbe
Vb(Q12) = Vsd + 2Vbe - Vbe - 3.5Vbe, or,
(xi)     Vb(Q12) = Vsd - 2.5Vbe

Note the unusual configuration of transistor Q8. The base-emitter and base-collector junctions are reverse biased in parallel. In this way, a large value, space-efficient capacitor is obtained. In order to satisfy the current source Ics2, transistor Q12 must build up incremental base charge to attain an appropriate Vbe value. The Q8 capacitor, if sized properly, can transmit an appropriate amount of charge to the base of Q12 much faster than the R6, Q7 combination can, thus providing significant delay performance enhancement.

Clamped Level-Shifted Input Translator: Incoming TTL input signals are converted into a Vbe voltage delta at node 1, as described earlier. In this section, the operation of the V(1)-translator circuit is described.

Let Ics1 represent the current required to satisfy the current source set-up by Q14 and R10.

Ics1 = {VCS - Vbe(Q14)} / R10

Ics1 is sourced by the parallel combination of transistor Q5 and resistor R4. The Ics1 value must be chosen to provide adequate current to bias transistor Q5 in the forward-active mode, while also allowing I(R4) to be satisfied. A first order approximation,

I(R4) = Vbe(Q5) / R4 and,
Ie(Q5) = Ics1 - I(R4).

Note that Vbe(Q5) is in fact a function of Ie(Q5).

V(R3) = R3 * I(R4) + {Ie(Q5) / (Hfe + 1)}

where Hfe is the current gain of Q5. Therefore, by an appropriate choice of R3, we can set up an appropriate amount of total voltage level shift provided by this circuit. Let us choose,

(xii)     R3 : R4 = 3 : 1.

Then, if we define Hfe to be a large positive number,

(xiii)     V(R3) = 3 * V(R4) = 3 * Vbe(Q5)

Therefore, the total voltage translation from node 1 to the base of transistor Q11 is set to be 4Vbe.

From our earlier discussion (Eq. ii),

Vref - Vsd + 2Vbe.

Hence, applying the voltage translation derived above, we find that,

(xiv)     Vb(Q11) = V(1) - 4Vbe

Applying the earlier V(I)HIGH and V(1)LOW limits, (Eqs. iv & viii) we find that,

(xv)     Vb(Q11)HIGH - V(1)HIGH - 4Vbe = Vsd - 2Vbe,
and,
(xvi)     Vb(Q11)LOW = V(1)LOW - 4Vbe = Vsd - 3Vbe

Comparing Eqs. xv and xvi versus Eq. xi, we find that the original incoming TTL input VIL, VIH voltage values have been interpreted into ECL-type voltage values Vb(Q11)HIGH or Vb(Q11)LOW. Further, an appropriate reference with excellent inherent tracking across wide voltage temperature and process variations has also been created.

Note the unusual configuration of transistor Q4. The base-emitter and base-collector junctions are reverse biased in parallel. In this way, a large value, space efficient capacitor is obtained. When an input transition is detected, the Q4 capacitor, if sized properly, transmits an appropriate amount of charge to the base of Q11 much faster than the R4, Q5 combination can, thus providing significant delay performance enhancement. The output emitter followers Q17 / Ioef1 and Q16 / Ioef2 perform the normal voltage level-shifting and provide current drive capability.

True ECL Buffer Driver: The key to the optimal performance of this circuit lies in the creation of the Vb(Q11) and Vb(Q12) voltages as described above. Once those appropriately conditioned voltages are available, the ECL current switch operates in the normal manner. Resistors R7, R8 and R11, and transistors Q11, Q12 and Q13 form the ECL current switch. If Vb(Q11) > Vb(Q12), then Ics2 is satisfied from ECL VCC via R7, and Vb(Q17) attains an ECL LOW output level, while Vb(Q16) attains an ECL HIGH level. Conversely, if Vb(Q11) < Vb(Q12) then Ics2 is satisfied from ECL VCC via R8, and Vb(Q16) attains an ECL LOW output level, while Vb(Q17) attains an ECL HIGH level.

OUTPUT CIRCUIT: Figure 2 shows the tri-state bus driver circuit C. The circuit shown in Figure 2 accepts true ECL inputs and drives a tri-state true TTL bus. The circuit in Figure 2 per se is described and claimed in copending application EP-A-0 317 143 entitled "TTL Output Translator Driver with ECL Tri-State Control" The tri-state bus driver circuit C shown in Figure 2 consists of fifteen transistors QQ1 to QQ15, ten resistors RR1 to RR10, and three diodes DD1 to DD3. The circuit operates as follows:

The Input Section III: As Fig 2 illustrates, the tri state bus driver circuit C has an (ECL) input section III that includes devices QQ1, QQ2, QQ3 and RR11 that operate to perform a current-steered switching function. If Vb(Q1) > Vr1, then transistor QQ1 develops a full Vbe and goes into forward-active conduction, while transistor QQ2 attains < 0.5Vbe and is considered cut-off. Hence, current source Ics1 (QQ3/RR11) is satisfied by QQ1. If Vb-(QQ1) < Vr1, then transistor QQ2 develops a full Vbe, and goes into forward-active conduction, while transistor QQ1 attains < 0.5Vbe and is considered cut-off. Hence, current source Ics1 (QQ3/RR11) is satisfied by QQ2. Note that Vbe is the nominal forward voltage of the bipolar transistor QQ1 (and QQ2). The Vbe voltage is set by device characteristics as a function of device current. All devices in this circuit are designed to appropriate dimensions such that with the defined nominal emitter current, the transistors attain uniform Vbe voltages.

If Vb(QQ1) > Vr1, then the QQ1 emitter current, Ie(QQ1), is set by:

(i)     $Ie(QQ1) = [Hfe / (Hfe + 1)] * \{[VCS - Vbe(QQ3)] / RR11\}$

If Vb(QQ1) < Vr1, then the QQ2 emitter current, Ie(QQ2), is set by,

(ii)     $Ie(QQ2) = [Hfe / (Hfe + 1)] * \{[VCS - Vbe(QQ3)] / RR11\}$

Let Vb(QQ1) < Vr1. Then, Ics1 is satisfied by ECL VCC through QQ2. In this case, resistor RR1 sources current I(RR1),

(iii)     $I(RR1) = TTL VCC - Vbe(QQ4)] / RR1$

through TTL VCC, to the base of transistor QQ4. This excess base drive forces transistor QQ4 to transition from the forward-active mode to the saturation mode. Consequently, the Schottky diode, in parallel with the base-collector function of transistor QQ4, clamps node 11 to a voltage greater than TTL GND by VCEsat. We define VCEsat to be 0.25Vbe. In this way, the V(1)LOW voltage level is established.

Let Vb(QQ1) > Vr1. Then, Ics1 is satisfied by TTL VCC through QQ1, RR1, QQ5 and RR2 as follows,

(iv)     $Ic(QQ1) = \{[Hfe / (Hfe + 1)]^{**} 2\}* Ics1$, and

(v)     $Ic(QQ1) = I(RR1) + Ie(QQ5)$

Resistor RR1 is chosen to be a sufficiently high value to ensure that,

(vi)     $Ic(QQ1) * RR1 > TTL VCC - TTL GND.$

Consequently, RR1 alone cannot source Ic(QQ1) completely. When Ics1 is steered into the QQ1 path, V(2) begins to move downward toward TTL GND. Transistor QQ4 is no longer supplied an excess base current. It therefore returns to a forward-active mode from the saturated mode. Note that transistors QQ4 and QQ5 are configured to provide a strong stabilizing feedback such that node 11 attains a voltage V(1) = 2Vbe. In this way, the V(1)HIGH voltage level is established.

True TTL Inverter / Output Driver: Devices DD1, DD3, QQ8, QQ10, QQ11, QQ12, QQ13, RR3, RR5, RR6, RR7, RR8 and RR9 are used to perform the TTL inverter/driver function. This is accomplished as follows.

Let V(1) = V(1)LOW = VCEsat. Then, Vsd-(DD1) is established by the flow of current I(RR3), which is given by,

(vii)     $TTL VCC - [I(R3) * RR3] - Vsd(DD1) - VCEsat(QQ4) = 0$

(viii)     $I(RR3) = [TTL VCC - Vsd - VCESat] / RR3$

Note that Vsd(DD1) is a slow function of I(RR3) at or near the nominal Vsd / Id operating point. I(RR3) is designed such that transistor QQ8 can be provided sufficient base current overdrive in one mode, and Schottky diode DD1 develops a nominal Vsd in the other mode. Now, since I(RR3) is conducted via diode DD1 and transistor QQ4 to TTL GND,

(ix)     $Vb(QQ8) = VCEsat + Vsd$

However, in order for QQ12 to force a VCEsat voltage at the output YA, Vb(QQ8) needs to be,

(x)     $Vb(QQ8) = Vbe(QQ8) + Vbe(QQ12) >= \sim2Vbe$

Since Vb(QQ8) < ~2Vbe, with reference to eqs. ix and x, we find that a full Vbe is not sustained across transistor QQ12. Therefore, transistors QQ8 and QQ12 are in the cut-off mode, and V(4) tends toward TTL VCC. As a result, the Darlington configured transistor pair, QQ10 & QQ11, acts as an emitter follower in driving the output YA. VOH(YA) is established as,

(xi)    VOH(YA) = TTL VCC - [I(RR5) * RR5] - Vbe(QQ10) - Vbe(QQ11)

Let V(1) = V(1)HIGH = ~2Vbe. Then, Schottky diode DD1 is in the zero-biased mode, and the flow of current I(RR3) is given by,

(xii)    TTL VCC - [I(RR3) * RR3] - Vbe(QQ8) - Vbe(QQ12) = 0

(xiii)    I(RR3) = [TTL VCC - 2Vbe] / RR3

Note that Vbe is a slow function of Ie at or near the nominal Vbe / Ie operating point. I(RR3) is designed such that transistor QQ8 can be provided sufficient base current overdrive to force it into the saturated mode.

(xiv)    Vb(QQ8) = Vbe(QQ8) + Vbe(QQ12) = ~2Vbe

which is exactly the value required at Vb(QQ8) in order for QQ12 to force a VCEsat voltage at the output YA. Since Vb(QQ8) = ~2Vbe, with reference to eqs. x and xiv, we find that transistor QQ8 saturates such that V(44) tends to,

(xv)    V(4) = VCEsat(QQ8) + Vbe(QQ12)

In this case, the I(RR3) and I(RR5) currents are drawn from TTL VCC to TTL GND via transistors QQ12 and QQ13. I(RR3) and I(RR5) can be defined as,

(xvi)    I(RR3) = [TTL VCC - 2Vbe] / RR3

(xvii)    I(RR5) = [TTL VCC - VCEsat - Vbe] / RR3

From eq. xv, we note that the Darlington configured transistor pair, QQ10 & QQ11, is cut-off for all output voltages such that,

(xviii)    VO(YA) + Vbe(QQ11) + Vbe(QQ10) > VCEsat(QQ8) + Vbe(QQ12)

This inequality is satisfied for all legitimate TTL VOL values. Due to the combined I(RR3) and I(RR5) currents flowing through transistors QQ12 and QQ13, both devices operate in the saturated mode. Consequently, VOL(YA) is established as,

(xix)    VOL(YA) = VCEsat(QQ12)

Devices RR8, RR9 and QQ13 improve the edge transition delay performance of the circuit. Briefly, during the V(55) transition from ~0.5Vbe to Vbe, QQ13 attains a nominal forward-active Vbe later than transistor QQ121, thus reducing the time needed by QQ12 to move VO(YA) from VOH to VOL. When V(5) transitions from Vbe to 0.5Vbe, RR8, RR9 and QQ13 need to be designed such that QQ13 exits the saturated mode after QQ12 has transitioned from the saturated mode to cut-off mode.

In the analysis presented above, a single input - A - has been used to illustrate the inverter function. However, this circuit technique can also be extended to allow multiple input OR / NOR functions, as well as series-gated multiple input AND functions.

True ECL Tri-State Enable / Disable Control: The circuit combination formed by the components of circuit 10 (i.e., devices R2, Q9 Q6 and D2 - see also Figs 1 and 3) and devices QQ9, QQ14, QQ15, QQ16 and RR10 perform the fast tri-state control function. The current steering switch is designed to accept normal internal true ECL levels, referenced against VA1. CT is the tri-state control input signal which operates at the nominal internal true ECL voltage levels.

If V(CT) < VA1, then the current I(RR10) is provided by ECL VCC via transistor QQ14. In this case, I(RR10) is given by,

(xx)    I(RR10) = [VA1 - Vbe(QQ14)] / RR10

and the output is not tri-stated, but rather behaves as a TECL-to-TTTL inverter/translator driver.

If V(CT) > VA1, then the current I(RR10) is provided by ECL VCC via transistors QQ16 and QQ15 from node 44. In this case, I(RR10) is,

(xxi)    Ic(QQ16) = [(Hfe / Hfe + 1) ** 2] * I-(RR10)

If the input A is at a low level, then V(1) = VCEsat and V(33) < 2Vbe. Thus, transistor QQ8 is in the cut-off mode, and V(44) approaches TTL VCC. With this set-up, when CT is asserted, transistor QQ16 turns on to source I(RR10) via node 44. The current is initially sourced from resistor RR5. However, the value of resistor RR5 is chosen such that,

(xxii)    Ic(QQ16) * RR5 > TTL VCC - ECL VCC

Note that TTL GND and ECL VCC are connected together for this circuit, which is the normal condition. As the voltage at node 44 moves from TTL VCC toward ECL VCC / TTL GND transistor QQ9 transitions from the cut-off to the forward-active mode and effectively clamps V(44) at,

(xxiii)    V(44) = Vsd(D2 + Vbe(Q6 - Vbe(QQ9)

(xxiv)    V(44) = Vsd

above TTL GND / ECL VCC. This V(44) voltage ensures that TTL output totem-pole top and bottom drivers are in the cut-off mode, thus ensuring that output YA is in the high impedance, tri-stated mode.

In this case, the Ic(QQ16) current is sourced by Ie(QQ9) and I(RR5) as follows,

(xxv)    Ic(QQ16) = {[TTL VCC - V(44)] / RR5} + Ie(QQ9)

If the input A is at a high level, then V(1) = ~2Vbe, Schottky diode DD1 is zero-biased, and V(33) = ~2Vbe. In this mode, current I(RR3) flows to the base of transistor QQ8 causing it to enter the saturated mode.

(xxvi)    I(RR3) = [TTL VCC - Vbe(QQ8) - Vbe-(QQ12)] / RR3

Thus, transistor QQ8 effectively clamps V(44) at,

(xxvii)    V(44) = ~Vbe + VCEsat

Now, with input A at a high level, when CT is asserted, transistor QQ16 turns on to source I-(RR10) via node 44.

(xxviii)    Ic(QQ16) = {[Hfe / Hfe +1] ** 2} * I-(RR10)

In this case, the Ic(QQ16) current is sourced by I-(RR3), Ie(QQ15) and I(RR5) as follows,

(xxix)    I(RR3) = [TTL VCC - Vsd(D2) - Vsd-(QQ8)] / RR3

(xxx)    I(RR5) = [TTL VCC - Vsd] / RR5

(xxxi)    Ic(QQ16) = I(RR3) + I(RR5) + Ie(QQ9)

I(RR10) is chosen such that,

(xxxii)    [Ic(QQ16) * RR5] > [TTL VCC - TTL GND]

Thus, when CT is asserted and I(RR10) is sourced from node 44, V(44) begins to move toward TTL GND / ECL VCC until transistor QQ9 effectively clamps V(44) at,

(xxxiii)    V(44) = Vsd

above TTL GND / ECL VCC. This V(44) voltage ensures that TTL output totem-pole top and bottom drivers are in the cut-off mode, thus ensuring that output YA is in the high impedance, tri-stated mode.

Combined Circuit:

Figure 3 shows how the circuits in Figures 1 and 2 are combined in accordance the present invention. The present invention provides a combined circuit that performs the same function as would be performed by both the circuit in Figure 1 and the circuit in Figure 2; however, the combined circuit has less components than the sum of the components in the two individual circuits.

The novel circuit of the present invention provides an I/O transceiver (i.e., a receiver and a driver) in one combined circuit. The output driver and the input receiver functions are implemented using the techniques explained with reference to Figures 1 and 2; however, the circuits are combined in a unique way to achieve lower cost in device count and silicon real estate compared to the conventional solution using two independent circuits.

As shown in Figure 3 as well as Figs. 1 & 2, resistor R2, transistors Q9 and Q6 and diode D2 form a part of both circuits.

When combined as shown in Figure 3, the two circuits operate in exactly the same manner as previously explained with respect to Figures 1 and 2; however, the combined device count is lower, thereby lowering the cost in terms of components and chip real estate.

**Claims**

1.    A combined driver receiver circuit (A) coupled to receive true TTL signals from and provide true TTL signals to a bi-directional TTL bus, comprising:

a dual purpose circuit (10), including a plurality of circuit elements (R2, Q6, Q9, D2) arranged in series circuit configuration between a first supply voltage representing the TTL supply potential (TTL VCC) and a second supply voltage representing the ECL and TTL reference potential (ECL VCC, TTL GROUND), the dual purpose circuit being operable as an input reference generator for providing an input reference (Vref) and a tri-state output clamp voltage;

an input receiver circuit (B) operable to receive and translate the true TTL signals from the bi-directional TTL bus to true ECL level signals, the input receiver circuit utilizing the input reference voltage (Vref) of said dual purpose circuit means;

an output driver circuit (C) for accepting true ECL level signals and for providing therefrom true TTL level signals to the bi-directional TTL bus utilizing the tri-state output clamp voltage of the dual purpose circuit;

circuit means connecting both the input receiver circuit and the output driver circuit to the bi-directional TTL bus.

2. The combined driver receiver circuit of claim 1, wherein the output driver circuit (C) includes tri-state control means (QQ9, QQ14, QQ15, QQ16, R10) having a control input (CT) connected to receive an ECL control signal and coupled to place the output driver circuit in a high impedance state when the true ECL control signal is in a first state.

3. The combined driver receiver circuit of claim 1 or 2, wherein the dual purpose circuit (10) utilizes semiconductor elements (Q6, Q9, D2) to generate the input reference (Vref).

4. The apparatus of any one of the preceding claims, wherein the input receiver circuit includes means (Q2) coupled to receive the second voltage for defining states of the true TTL signals.

5. The apparatus of any one of the preceding claims, wherein the plurality of circuit elements comprises a number of semiconductor diode elements (Q6, Q9, D2) connected in series between the first voltage (TTL VCC) and the second voltage (ECL VCC) to provide the input reference voltage (Vref); a first one of the diode elements (Q9) having a lead element at which is provided the input reference voltage.

6. The apparatus of claim 5, wherein a second one of the diode elements (Q6) includes a lead element at which is provided the tri-state output clamp voltage.

7. The apparatus of claim 6, wherein the first and second diode elements (Q6, Q9) are each formed from a transistor junction.

8. The apparatus of any one of the preceding claims, the apparatus being formed as part of a single semiconductor chip.

9. The apparatus of any one of the preceding claims, wherein the output driver circuit includes first and second output transistors (QQ11, QQ12) coupled to provide a true TTL signal of a first state in response to a first true ECL signal, and a true TTL signal of the second state in response to a second true ECL signal.

**Patentansprüche**

1. Kombinierte Treiber/Empfänger-Schaltung (A), die so anschließbar ist, daß sie echte TTL-Signale von einem bidirektionalen TTL-Bus empfängt und an diesen echte TTL-Signale abgibt, mit:

einem Doppelfunktions-Schaltkreis (10) mit einer Mehrzahl von Schaltelementen (R2, Q6, Q9, D2), die in einer Reihenschaltungsanordnung zwischen einer ersten, das TTL-Versorgungspotential darstellenden Versorgungsspannung und einer zweiten, das ECL- und TTL-Bezugspotential (ECL VCC, TTL GND) darstellenden Versorgungsspannung angeordnet sind, wobei der Doppelfunktions-Schaltkreis als Eingangsreferenzgenerator betreibbar ist, um eine Eingangs-Bezugsspannung (Vref) und eine Ausgangsklemmspannung für drei Zustände zu liefern;

einem Eingangs-Empfängerschaltkreis (B), der ausgebildet ist, die echten TTL-Signale vom bidirektionalen TTL-Bus zu empfangen und in Signale auf echtem ECL-Pegel umzusetzen, wobei der Eingangs-Empfängerschaltkreis die Eingangs-Bezugsspannung (Vref) des Doppelfunktions-Schaltkreises verwendet;

einem Ausgangs-Treiberschaltkreis (C) zur Annahme von Signalen auf echtem ECL-Pegel und zur Abgabe von hieraus gewonnenen Signalen auf echtem TTL-Pegel an den bidirektionalen TTL-Bus unter Verwendung der vom Doppelfunktions-Schaltkreis gelieferten Ausgangs-Klemmspannung für drei Zustände;

Schaltgliedern, die sowohl den Eingangs-Empfängerschaltkreis als auch den Ausgangs-Treiberschaltkreis mit dem bidirektionalen TTL-Bus verbinden.

2. Kombinierte Treiber/Empfänger-Schaltung nach Anspruch 1, wobei der Ausgangs-Treiberschaltkreis (C) eine Steuereinrichtung (QQ9, QQ14, QQ15, QQ16, R10) zum Ansteuern eines von drei Zuständen aufweist, mit einem Steuereingang (CT), der so angeschlossen ist, daß er ein ECL-Steuersignal empfängt, und so geschaltet ist, daß der Ausgangs-Treiberschaltkreis in einen Zustand hoher Impedanz gebracht wird, wenn sich das echte ECL-Steuersignal in einem ersten Zustand befindet.

3. Kombinierte Treiber/Empfänger-Schaltung nach Anspruch 1 oder 2, wobei der Doppelfunktions-Schaltkreis (10) Halbleiterelemente (Q6, Q9, D2) verwendet, um die Eingangs-Bezugsspannung (Vref) zu erzeugen.

**4.** Vorrichtung nach einem der vorhergehenden Ansprüche, wobei der Eingangs-Empfängerschaltkreis eine Einrichtung (Q2) aufweist, die so angeschlossen ist, daß sie die zweite Spannung empfängt, um Zustände der echten TTL-Signale zu definieren.

**5.** Vorrichtung nach einem der vorhergehenden Ansprüche, bei der die besagte Mehrzahl von Schaltelementen eine Anzahl von Halbleiterdiodenelementen (Q6, Q9, D2) umfaßt, die in Reihe zwischen die erste Spannung (TTL VCC) und die zweite Spannung (ECL VCC) geschaltet sind, um die Eingangs-Bezugsspannung (Vref) zu liefern; wobei ein erstes der Diodenelemente (Q9) ein Leitungselement aufweist, an dem die Eingangs-Bezugsspannung bereitgestellt wird.

**6.** Vorrichtung nach Anspruch 5, bei der ein zweites der Diodenelemente (Q6) ein Leitungselement aufweist, an dem die Ausgangs-Klemmspannung für drei Zustände bereitgestellt wird.

**7.** Vorrichtung nach Anspruch 6, bei der das erste und das zweite Diodenelement (Q6, Q9) jeweils aus einem Transistorübergang gebildet sind.

**8.** Vorrichtung nach einem der vorhergehenden Ansprüche, wobei die Vorrichtung als Teil eines einzigen Halbleiterchips ausgebildet ist.

**9.** Vorrichtung nach einem der vorhergehenden Ansprüche, bei welcher der Ausgangs-Treiberschaltkreis einen ersten und einen zweiten Ausgangs-Transistor (QQ11, QQ12) umfaßt, die so angeschlossen sind, daß sie bei Anliegen eines ersten echten ECL-Signals ein echtes TTL-Signal in einem ersten Zustand liefern und bei Anliegen eines zweiten echten ECL-Signals ein echtes TTL-Signal in einem zweiten Zustand liefern.

**Revendications**

**1.** Circuit récepteur-pilote combiné (A) couplé pour recevoir des signaux en logique transistor-transistor TTL vraie en provenance d'un bus TTL bidirectionnel et pour fournir à ce bus des signaux en logique TTL vraie, circuit comportant:

un circuit à double usage (10) comprenant une pluralité d'éléments de circuit (R2, Q6, Q9, D2) disposés en configuration de circuit série entre une première tension d'alimentation, représentant le potentiel d'alimentation en logique TTL et une seconde tension d'alimentation représentant le potentiel de référence en logique à couplage par les émetteurs ECL et en logique transistor-transistor TTL (ECL VCC, TTL GROUND), le circuit à double usage pouvant fonctionner comme générateur de tension de référence d'entrée pour fournir une tension de référence d'entrée (Vref) et une tension à niveau fixé à la sortie à trois états;

un circuit récepteur d'entrée (B) pouvant fonctionner pour recevoir et convertir les signaux en logique TTL vraie, en provenance du bus TTL bidirectionnel, en signaux de niveau de logique ECL vraie, le circuit récepteur d'entrée utilisant la tension de référence d'entrée (Vref) dudit moyen formant circuit à double usage;

un circuit pilote de sortie (C) pour recevoir les signaux de niveau de logique ECL vraie et pour, à partir de ces signaux, fournir des signaux de niveau de logique TTL vraie au bus TTL bidirectionnel en utilisant la tension à niveau fixé à la sortie à trois états du circuit à double usage;

des moyens formant circuits reliant à la fois le circuit récepteur d'entrée et le circuit pilote de sortie au bus TTL bidirectionnel.

**2.** Circuit récepteur-pilote combiné de la revendication 1, dans lequel le circuit pilote de sortie (C) comporte des moyens de commande à trois états (QQ9, QQ14, QQ15, QQ16, RR10) présentant une entrée de commande (CT) reliée pour recevoir un signal de commande en logique ECL et couplée pour placer le circuit pilote de sortie dans un état de haute impédance lorsque le signal de commande en logique ECL est dans un premier état.

**3.** Circuit récepteur-pilote combiné de la revendication 1 ou de la revendication 2, dans lequel le circuit à double usage (10) utilise des éléments semi-conducteurs (Q6, Q9, D2) pour générer la tension de référence d'entrée (Vref).

**4.** Appareil de l'une quelconque des revendications précédentes, dans lequel le circuit récepteur d'entrée comporte des moyens (Q2) couplés pour recevoir la seconde tension pour définir les états des signaux en logique TTL vraie.

**5.** Appareil de l'une quelconque des revendications précédentes, dans lequel la pluralité des éléments de circuit comporte un certain nombre d'éléments semi-conducteurs formant diodes (Q6, Q9, D2) reliés en série entre la première tension (TTL VCC) et la seconde tension (ECL VCC) pour fournir la tension de référence d'entrée (Vref); un premier des éléments formant diodes (Q9) présentant un élément conducteur auquel est fournie la tension de référence d'entrée.

6. Appareil de la revendication 5, dans lequel un second des éléments formant diodes (Q6) comprend un élément conducteur auquel est fournie la tension à niveau fixé à la sortie à trois états.

7. Appareil de la revendication 6, dans lequel le premier et le second éléments formant diodes (Q6, Q9) sont chacun formés à partir d'une jonction de transistor.

8. Appareil de l'une quelconque des revendications précédentes, l'appareil étant formé en tant que partie d'une unique microplaquette de semi-conducteur.

9. Appareil de l'une quelconque des revendications précédentes, dans lequel le circuit pilote de sortie comporte un premier et un second transistors de sortie (QQ11, QQ12) couplés pour fournir un signal en logique TTL vraie d'un premier état en réponse à un premier signal en logique ECL vraie, ainsi qu'un signal en logique TTL vraie d'un second état en réponse à un second signal en logique ECL vraie.

EP 0 317 144 B1

FIG.__1.

FIG._2.

FIG._3.